(19) Europäisches Patentamt
European Patent Office
Office européen des brevets

(11) EP 4 610 672 A1

(12) EUROPEAN PATENT APPLICATION
published in accordance with Art. 153(4) EPC

(43) Date of publication:
03.09.2025 Bulletin 2025/36

(51) International Patent Classification (IPC):
$G01R\ 27/20^{(2006.01)}$  $H02S\ 50/00^{(2014.01)}$

(21) Application number: 23902276.7

(86) International application number:
PCT/CN2023/125318

(22) Date of filing: 19.10.2023

(87) International publication number:
WO 2024/125075 (20.06.2024 Gazette 2024/25)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 12.12.2022 CN 202211591079

(71) Applicant: Hoymiles Power Electronics Inc.
Hangzhou, Zhejiang 310015 (CN)

(72) Inventors:
• SHI, Keyan
  Hangzhou, Zhejiang 310015 (CN)
• YU, Hongbin
  Hangzhou, Zhejiang 310015 (CN)
• ZHAO, Yi
  Hangzhou, Zhejiang 310015 (CN)
• YANG, Bo
  Hangzhou, Zhejiang 310015 (CN)

(74) Representative: Petraz, Gilberto Luigi et al
GLP S.r.l.
Viale Europa Unita, 171
33100 Udine (IT)

(54) **GROUNDING IMPEDANCE MEASUREMENT APPARATUS AND METHOD, AND INVERTER**

(57) A grounding impedance measurement apparatus and method, and an inverter are provided. The measurement apparatus includes a signal source, a coupling impedance network, a voltage division network, a sampling module, and a controller, the coupling impedance network is connected to the signal source, and couples an excitation signal between a direct-current input terminal and an alternating-current output terminal of an inverter; the voltage division network performs voltage division on the voltage between the direct-current input terminal and the alternating-current output terminal to provide a divided voltage; the sampling module is connected to the voltage division network, samples the divided voltage, and acquires a sampled voltage; and the controller is connected to the signal source and the sampling module, respectively, and acquires a grounding impedance of the direct-current input terminal of the inverter.

FIG. 1

EP 4 610 672 A1

**Description**

**CROSS-REFERENCE TO RELATED APPLICATIONS**

This application claims priority to Chinese patent application No. 202211591079.0, filed on December 12, 2022, and titled "GROUNDING IMPEDANCE MEASUREMENT APPARATUS AND METHOD, AND INVERTER". The contents of the above identified applications are hereby incorporated herein in their entireties by reference.

**TECHNICAL FIELD**

The present invention generally relates to the field of photovoltaic power generation technology, and in particular, to a grounding impedance measurement apparatus and method, and an inverter.

**BACKGROUND**

In a photovoltaic grid-connected system, when a DC (direct current) resistance of an output terminal of a photovoltaic module to the ground is too small, short-circuit risks on a DC side and an AC (Alternating Current) side will result in system security risks. Therefore, it needs to perform grounding impedance detection on the DC side for the photovoltaic grid-connected system.

Currently, most inverters have a metal housing and the housing is grounded. In a used grounding impedance detection manner, a grounding potential point of the housing is used. In a detection method, a resistance with a fixed resistance value is connected between the grounding potential point of the housing and a positive electrode of the photovoltaic assembly, and between the grounding potential point of the housing and a negative electrode of the photovoltaic assembly, respectively, by switching of a relay or a semiconductor switch. Meanwhile, voltage values at the grounding potential point of the housing are collected successively, and a grounding impedance value between two terminals of the photovoltaic module and the ground are calculated according to the voltage values.

Due to these methods use the grounding potential point of the housing, these methods are not applicable to inverters that are non-metallic and have no grounding wire connection.

**SUMMARY**

According to various embodiments of the present invention, a grounding impedance measurement apparatus and method, and an inverter are provided.

In a first aspect, a grounding impedance measurement apparatus is provided in the present invention, including a signal source, a coupling impedance network, a voltage division network, a sampling module, and a controller. The signal source is configured to provide an excitation signal. The coupling impedance network is connected to the signal source, and configured to couple the excitation signal between a direct-current input terminal and an alternating-current output terminal of an inverter, and the alternating-current output terminal of the inverter is connected to a power grid. The voltage division network is configured to perform voltage division on a voltage between the direct-current input terminal and the alternating-current output terminal to provide a divided voltage. The sampling module is connected to the voltage division network, and configured to sample the divided voltage and acquire a sampled voltage. The controller is connected to the signal source and the sampling module, respectively, and configured to control the signal source to provide at least one excitation signal and acquire a grounding impedance of the direct-current input terminal of the inverter according to the at least one excitation signal and the sampled voltage corresponding to the at least one excitation signal.

In some embodiments, the controller is further configured to control the signal source to provide a first excitation signal and a second excitation signal, respectively, the sampling module is further configured to acquire a first sampled voltage corresponding to the first excitation signal and a second sampled voltage corresponding to the second excitation signal, and the controller is further configured to acquire the grounding impedance of the direct-current input terminal of the inverter according to a difference between the first excitation signal and the second excitation signal and a difference between the first sampled voltage and the second sampled voltage.

In some embodiments, an output terminal of the signal source is connected to a port of the direct-current input terminal and the other output terminal of the signal source is connected to a port of the alternating-current output terminal via the coupling impedance network.

In some embodiments, the signal source includes a direct-current voltage conversion circuit or a rectifier circuit.

In some embodiments, the signal source includes a switch circuit, which includes at least one switch, and different excitation signals are output by controlling an on-state of the at least one switch.

In some embodiments, the inverter includes a full-bridge circuit or a half-bridge circuit, which is connected to the direct-current input terminal, the signal source is a part of the full-bridge circuit or a part of the half-bridge circuit, and the excitation signal includes a direct-current input voltage of the direct-current input terminal or 0.

In some embodiments, the voltage division network is connected between a port of the direct-current input terminal of the inverter and a port of the alternating-current output terminal of the inverter.

In some embodiments, the voltage division network is connected to the coupling impedance network in series.

In some embodiments, the sampling module includes a first sampling unit, which is connected to the voltage division network and configured to acquire the sampled voltage.

In some embodiments, the first sampling unit includes a filtering circuit and a sampling circuit, and the filtering circuit is connected to the voltage division network and the sampling circuit, respectively, and configured to filter a voltage component in the sampled voltage other than a voltage component with a frequency of the excitation signal.

In some embodiments, the controller includes a filtering unit configured to filter a voltage component in the sampled voltage other than a voltage component with a frequency of the excitation signal.

In some embodiments, the sampling module further includes a second sampling unit connected to the direct-current input terminal of the inverter and configured to acquire a direct-current input voltage and provide the direct-current input voltage to the controller, and the controller is configured to control the signal source to provide at least two different excitation signals, and acquire the grounding impedance of the direct-current input terminal of the inverter according to the at least two different excitation signals and sampled voltages and direct-current input voltages corresponding to the at least two different excitation signals.

In some embodiments, the excitation signal includes a direct-current signal, an alternating-current signal, or a superposed signal of a direct-current signal and an alternating-current signal.

In some embodiments, the controller is configured to compare the grounding impedance with a preset threshold to determine whether the grounding impedance is abnormal.

In a second aspect, a grounding impedance measurement method is provided in the present invention, which is configured to measure a grounding impedance of a direct-current input terminal of an inverter. The method includes: coupling at least one excitation signal between the direct-current input terminal and an alternating-current output terminal of the inverter; performing voltage division on a voltage between the direct-current input terminal and the alternating-current output terminal of the inverter to obtain a sampled voltage; and acquiring a grounding impedance of the direct-current input terminal of the inverter according to the at least one excitation signal and the sampled voltage corresponding to the at least one excitation signal.

In some embodiments, the method further includes: coupling a first excitation signal and a second excitation signal between the direct-current input terminal and the alternating-current output terminal of the inverter, respectively; and acquiring a first sampled voltage corresponding to the first excitation signal and a second sampled voltage corresponding to the second excitation signal, respectively, and acquiring the grounding impedance of the direct-current input terminal of the inverter according to a difference between the first excitation signal and the second excitation signal and a difference between the first sampled voltage and the second sampled voltage.

In some embodiments, the method further includes: coupling at least two different excitation signals between the direct-current input terminal and the alternating-current output terminal of the inverter, respectively; and acquiring direct-current input voltages of the direct-current input terminal of the inverter and sampled voltages corresponding to the at least two different excitation signals, and acquiring the grounding impedance of the direct-current input terminal of the inverter according to the at least two different excitation signals and the direct-current input voltages and the sampled voltages corresponding to the at least two different excitation signals.

In some embodiments, the method further includes: comparing the grounding impedance with a preset threshold to determine whether the grounding impedance is abnormal.

In a third aspect, an inverter is provided in the present invention, including the grounding impedance measurement apparatus in the first aspect and a DC/AC converter. The DC/AC converter is connected between the direct-current input terminal and the alternating-current output terminal of the inverter and configured to convert a direct current to an alternating current.

According to the grounding impedance measurement apparatus and the method, and the inverter, the signal source and the coupling impedance network are disposed between the direct-current input terminal and the alternating-current output terminal of the inverter, to construct a high-resistance circuit. The excitation signal is introduced into the high-resistance circuit, and the grounding impedance of the direct-current input terminal of the inverter is acquired according to the excitation signal and the sampling voltage corresponding to the excitation signal. In a case that the inverter has no grounding line, the grounding impedance of the direct-current input terminal of the inverter is measured, and the measurement apparatus has a simple structure and is easy to implement.

Details of one or more embodiments of the present invention are proposed in the following accompanying drawings and descriptions, so that other features, objects, and advantages of the present invention are more easily understood.

## BRIEF DESCRIPTION OF THE DRAWINGS

In order to more clearly describe technical solutions in the embodiments or the related art, the following briefly describes the accompanying drawings required for describing the embodiments or the conventional technologies. Apparently, the accompanying drawings in the following description show merely the embodiments of the present invention, and one skilled in the art may still derive other drawings from the disclosed accompanying drawings without creative efforts.

FIG. 1 is a block diagram of a power generation system in some embodiments.
FIG. 2 is a schematic diagram of a grounding impedance measurement apparatus in some embodiments.
FIG. 3 is a direct-current equivalent circuit model of FIG. 2.
FIG. 4 is an alternating-current equivalent circuit model of FIG. 2.
FIG. 5 is a schematic diagram of a grounding impedance measurement apparatus in some embodiments.
FIG. 6 is a schematic diagram of a grounding impedance measurement apparatus in some embodiments.
FIG. 7 is a direct-current equivalent circuit model of FIG. 6.
FIG. 8 is a schematic diagram of a signal source in some embodiments.
FIG. 9 is a schematic diagram of a signal source in some embodiments.
FIG. 10 is a schematic diagram of a signal source in some embodiments.
FIG. 11 is a schematic diagram of a signal source in some embodiments.
FIG. 12 is a schematic diagram of a first sampling unit in some embodiments.
FIG. 13 is a flowchart of a grounding impedance measurement method in some embodiments.

In the figures, 100 represents an inverter, 110 represents a grounding impedance measurement apparatus, 111 represents a coupling impedance network, 112 represents a voltage division network, 113 represents a sampling module, 113a represents a first sampling unit, 113b represents a second sampling unit, 113c represents a third sampling unit, 114 represents a controller, 115 represents a filtering circuit, 116 represents a sampling circuit, 120 represents a DC/AC converter, $V_c$ represents a signal source, $V_{pv}$ represents a direct-current input voltage, $R_1$ represents a first resistor, $R_2$ represents a second resistor, $R_3$ represents a third resistor, $R_4$ represents a fourth resistor, $R_x$ represents a fifth resistor, $R_{E1}$ represents a grounding impedance of a negative port of a direct-current input terminal, $R_{E2}$ represents a grounding impedance of a positive port of a direct-current input terminal, PE represents a grounding point, 200 represents a direct current source, 300 represents a power grid.

## DETAILED DESCRIPTION OF THE EMBODIMENT

The following clearly and completely describes the technical solutions in the embodiments of the present invention with reference to the accompanying drawings in the embodiments of the present invention. Apparently, the described embodiments are merely some rather than all of the embodiments of the present invention. Based on the embodiments of the present invention, all other embodiments obtained by one skilled in the art without creative efforts fall within the protection scope of the present invention.

When a component is considered to be "connected" to another component, it may be directly connected to another component or a centered component may be present. When one component is considered to be connected to another component "in series" or "in parallel", it may be either directly connected to another component in series or in parallel or may be accompanied by a centered component.

Unless otherwise defined, all technical and scientific terms used in this description have the same meaning as is generally understood by one skilled in the art that belong to the present invention. The terms used in the description of the present invention are merely intended to describe specific embodiments, and are not intended to limit the present invention.

A grounding impedance measurement apparatus provided in the present invention may be applied to a power generation system.

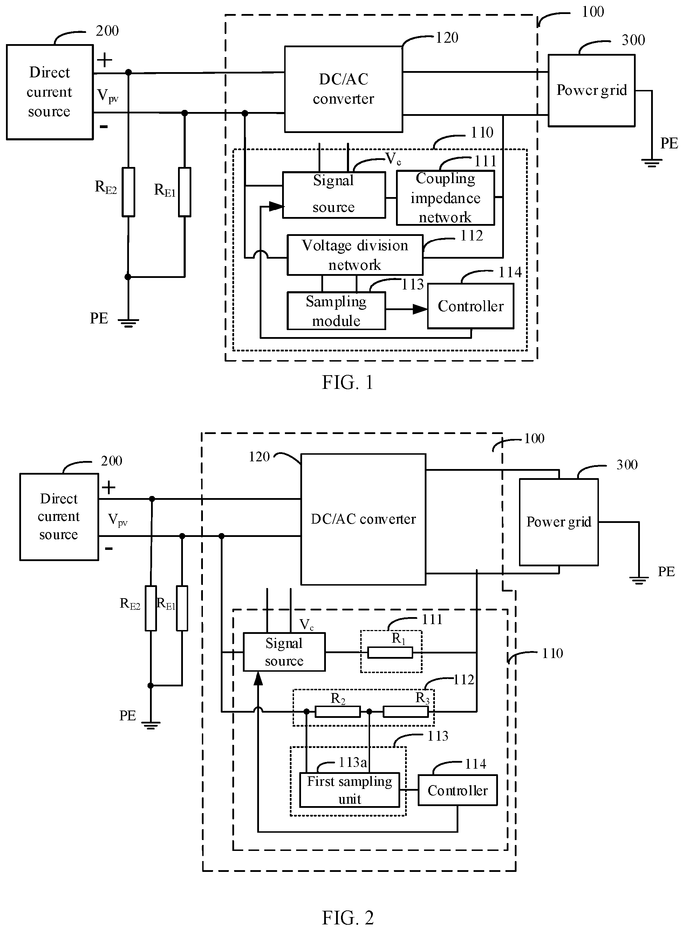

FIG. 1 is a block diagram of a power generation system provided in the present invention. Referring to FIG. 1, the power generation system may include an inverter 100 and a direct current source 200 connected to a direct-current input terminal of the inverter 100. The inverter 100 is configured to convert a direct current provided by the direct current source 200 into an alternating current, and further provide the alternating current to a power grid 300.

In some embodiments, the direct current source 200 may include a photovoltaic module.

In some embodiments, the direct current source 200 may include a photovoltaic string or an array formed by a plurality of photovoltaic modules connected in series and parallel, or may include a battery or another type of renewable energy source.

The inverter 100 may include an isolated or non-isolated inverter, and may include a single-stage inverter or a multi-stage inverter.

In some embodiments, a chassis of the inverter 100 may not be grounded.

The power grid 300 may be a single-phase power grid, a three-phase power grid, or a split-phase power grid.

A remote end of the power grid 300 may be grounded by a zero line. A grounding point may be located at a positive end of the power grid 300, or a negative end of the power grid 300. When the power grid is the split-phase grid, the grounding point may be located at a midpoint of the power grid 300. A location of the grounding point does not affect the grounding impedance measurement in the embodiment of the present invention.

Referring to FIG. 1, the inverter 100 includes a DC/AC converter 120 and a grounding impedance measurement apparatus 110, and the grounding impedance measurement apparatus 110 includes a signal source $V_c$, a coupling impedance network 111, a voltage division network 112, a sampling module 113, and a controller 114.

The signal source $V_c$ is connected between a direct-current input terminal and an alternating-current output terminal of the inverter 100 and configured to provide an excitation signal.

The coupling impedance network 111 is connected to the signal source $V_c$, and configured to couple the excitation signal between the direct-current input terminal and the alternating-current output terminal of the inverter 100. The alternating-current output terminal of the inverter 100 is connected to the power grid 300.

The voltage division network 112 is configured to perform voltage division on a voltage between the direct-current input terminal and the alternating-current output terminal to provide a divided voltage.

The sampling module 113 is connected to the voltage division network 112, and configured to acquire a sampled voltage of the voltage division network 112.

The controller 114 is connected to the signal source $V_c$ and the sampling module 113, respectively. The controller 114 is configured to control the signal source $V_c$ to provide at least one excitation signal and acquire a grounding impedance of the direct-current input terminal of the inverter 100 according to the at least one excitation signal and the sampled voltage corresponding to the at least one excitation signal.

In the present embodiment, the signal source $V_c$ and the coupling impedance network 111 are disposed between the direct-current input terminal and the alternating-current output terminal of the inverter 100, to construct a high-resistance circuit. The excitation signal is introduced into the high-resistance circuit, and the grounding impedance of the direct-current input terminal of the inverter 100 is acquired according to the excitation signal and the sampling voltage corresponding to the excitation signal.

It should be noted that the grounding impedance of the direct-current input terminal of the inverter 100 is the same as that of the direct current source 200 to the ground.

The signal source $V_c$ may collect power from the direct current source 200, or from other power supply of the power generation system. An input of the signal source $V_c$ may be a direct-current power supply, or may be an alternating-current power supply.

In some embodiments, a first output terminal of the signal source $V_c$ may be connected to a negative port of a direct-current input terminal of the DC/AC converter 120 (i.e., a negative port of the direct-current input terminal of the inverter 100), and a second output terminal of the signal source $V_c$ may be connected to a port of the alternating-current output terminal of the DC/AC converter 120.

In some embodiments, the first output terminal of the signal source $V_c$ may be connected to a positive port of the direct-current input terminal of the DC/AC converter 120 (i.e., a positive port of the direct-current input terminal of the inverter 100). By control of the controller 114, the second output terminal of the signal source $V_c$ may generate at least one controlled excitation signal relative to the first output terminal of the signal source $V_c$.

In some embodiments, the grounding impedance measurement apparatus 110 is configured in an inverter 100 with a non-metal housing and no grounding line. In a case that the inverter 100 has no grounding line, the grounding impedance of the direct current source 200 may be measured.

FIG. 2 is a schematic diagram of a grounding impedance measurement apparatus in an embodiment. Referring to FIG. 2, $R_{E1}$ represents a grounding impedance of a negative port of a direct-current output terminal of the direct current source 200 (i.e., the negative port of the direct-current input terminal of the inverter 100), and $R_{E2}$ represents a grounding impedance of a positive port of a direct-current output terminal of the direct current source 200 (i.e., the positive port of the direct-current input terminal of the inverter 100). The signal source $V_c$ is configured to provide the excitation signal. The coupling impedance network 111 may include a first resistor $R_1$. The first resistor $R_1$ may be connected to an output terminal of the signal source $V_c$ in series, and connected between a port of the direct-current input terminal of the DC/AC converter 120 and a port of the alternating-current output terminal of the DC/AC converter 120. The first resistor $R_1$ is configured to limit an impedance value between a DC side and an AC side of the inverter 100 when the inverter 100 is in operation normally.

Specifically, the first output terminal of the signal source $V_c$ may be connected to the negative port of the direct-current input terminal of the DC/AC converter 120, the second output terminal of the signal source $V_c$ may be connected to a first terminal of the first resistor $R_1$, and a second terminal of the first resistor $R_1$ may be connected to a first port of the alternating-current output terminal of the DC/AC converter 120.

In some embodiments, the first output terminal of the signal source $V_c$ may be connected to the positive port of the direct-current input terminal of the DC/AC converter 120, the second output terminal of the signal source $V_c$ may be connected to the first terminal of the first resistor $R_1$, and the second terminal of the first resistor $R_1$ may be connected to a second port of the alternating-current output terminal of the DC/AC converter 120.

In some embodiments, the voltage division network 112 may include a second resistor $R_2$ and a third resistor $R_3$, and the second resistor $R_2$ and the third resistor $R_3$ may be connected between the negative port of the direct-current input terminal of the DC/AC converter 120 and the first port of the alternating-current output terminal of the DC/AC converter 120.

In another embodiment, the second resistor $R_2$ and the third resistor $R_3$ may be connected between the positive port of the direct-current input terminal of the DC/AC converter 120 and the second port of the alternating-current output terminal of the DC/AC converter 120.

The sampling module 113 may include a first sampling unit 113a, which is configured to sample a voltage between two terminals of the second resistor $R_2$ to obtain a sampled voltage and provide the sampled voltage to the controller 114.

The controller 114 may control the signal source $V_c$ to provide a first excitation signal and a second excitation signal, respectively, the first sampling unit 113a may acquire a first sampled voltage corresponding to the first excitation signal and a second sampled voltage corresponding to the second excitation signal, respectively, and the controller 114 may acquire the grounding impedance of the direct-current input terminal of the inverter 100 according to a difference between the first excitation signal and the second excitation signal and a difference between the first sampled voltage and the second sampled voltage.

In some embodiments, a resistance value of the first resistor $R_1$ may be generally in a range from several MΩ to dozens MΩ.

In some embodiments, a resistance value of the third resistor $R_3$ may be generally in the same level as that of the first resistor $R_1$, and the resistance value may be in a range from several MΩ to dozens MΩ, while a resistance value of the second resistor $R_2$ configured for voltage sampling may be generally far less than that of the third resistor $R_3$.

Specifically, the signal source $V_c$ may output at least one excitation signal relative to the negative port of the direct-current input terminal of the DC/AC converter 120 by control of the controller 114, the corresponding sampling module 113 may sample and acquire at least one sampled voltage, and the controller 114 may obtain resistance values of the grounding impedance $R_{E1}$ and the grounding impedance $R_{E2}$ or a parallel resistance value of the grounding impedance $R_{E1}$ and the grounding impedance $R_{E2}$ according to the at least one excitation signal and the at least one sampled voltage corresponding to the at least one excitation signal, i.e., the grounding impedance of the direct-current input terminal of the inverter 100.

In some embodiments, the controller 114 may obtain the parallel resistance value of the grounding impedance $R_{E1}$ and the grounding impedance $R_{E2}$ according to at least two different excitation signals and sampled voltages under different disturbances.

The grounding impedance of the direct-current input terminal of the inverter 100 may include a grounding impedance of the positive port of the direct-current input terminal of the inverter 100 and a grounding impedance of the negative port of the direct-current input terminal of the inverter 100, or a parallel value of the grounding impedance of the positive port of the direct-current input terminal of the inverter 100 and the grounding impedance of the negative port of the direct-current input terminal of the inverter 100.

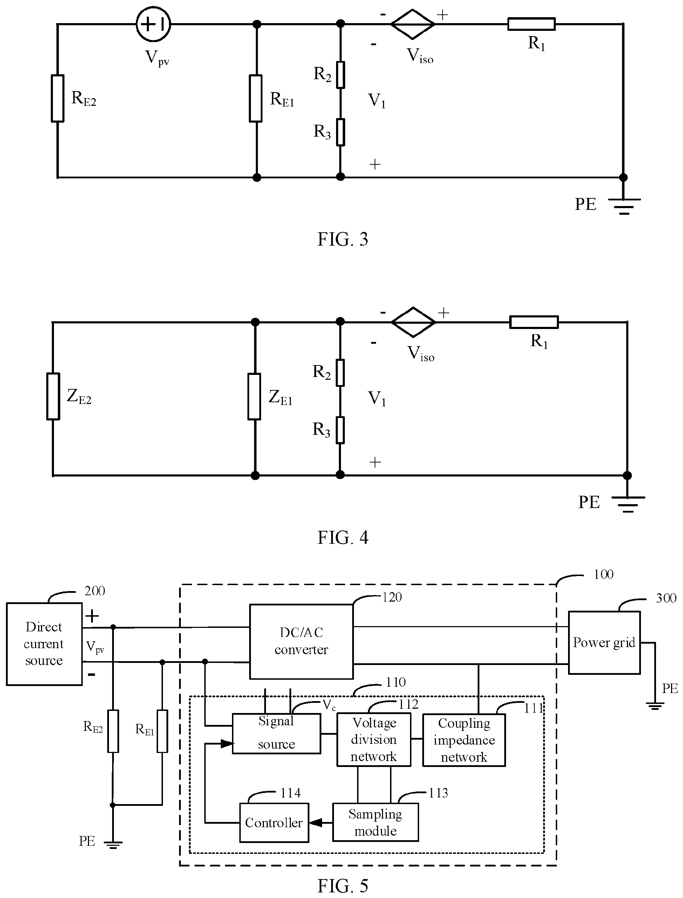

Referring to FIG. 2, the positive port of the direct-current output terminal of the direct current source 200 connected to the DC side of the inverter 100 may be connected to the ground by the grounding impedance $R_{E2}$, the negative port of the direct-current output terminal of the direct current source 200 connected to the DC side of the inverter 100 may be connected to the ground by the grounding impedance $R_{E1}$, and the AC side of the DC/AC converter 120 may connected to the ground by a zero line. Therefore, the first resistor $R_1$ and the signal source $V_c$ may be connected between the direct-current input terminal and the alternating-current output terminal of the DC/AC converter 120 to form a closed circuit. If only a DC component in the closed circuit is considered, the AC side of the inverter 100 may be equivalent to direct grounding regardless of a grounding form of the power grid connected to the AC side of the inverter 100. When only the DC component in the system is considered, the above grounding impedance measurement apparatus 110 may be simplified as a DC equivalent circuit model shown in FIG. 3. $V_{iso}$ may be the excitation signal output by the signal source $V_c$, the excitation signal Viso may include a DC voltage, $V_{pv}$ may be a DC output voltage of the direct current source 200, i.e., a DC input voltage of the direct-current input terminal of the inverter 100, and $V_{pv}$ may be a stable value in a measurement process. A voltage $V_1$ between two terminals of the second resistor $R_2$ and the third resistor $R_3$ shown in FIG. 3 may be represented as:

$$V_1 = \frac{R_{E1}//(R_2+R_3)//R_1}{R_{E2}+R_{E1}//(R_2+R_3)//R_1}V_{pv} + \frac{R_{E1}//(R_2+R_3)//R_{E2}}{R_1+R_{E1}//(R_2+R_3)//R_{E2}}V_{iso} \quad (1)$$

The sampled voltage $V_{sam}$ obtained by the first sampling unit 113a sampling a division voltage of the second resistor R2 may satisfy the following relationship:

$$V_{sam} = V_1 \frac{R_2}{R_2 + R_3}$$

The grounding impedance measurement in the present embodiment may include the following step 1 to step 5.

Step 1 may include the controller 114 controlling the signal source $V_c$ to output an excitation signal $V_{iso1}$.

Step 2 may include after the excitation signal $V_{iso1}$ output by the signal source $V_c$ is stabilized, the first sampling unit 113a sampling the division voltage between two terminals of the second resistor $R_2$ to obtain a sampled voltage $V_{sam1}$.

Step 3 may include the controller 114 controlling the signal source $V_c$ to output an excitation signal $V_{iso2}$.

Step 4 may include after the excitation signal $V_{iso2}$ output by the signal source $V_c$ is stabilized, the first sampling unit 113a sampling the division voltage between two terminals of the second resistor $R_2$ to obtain a sampled voltage $V_{sam2}$.

Step 5 may include acquiring the parallel resistance value of the grounding impedance $R_{E1}$ and the grounding impedance $R_{E2}$ according to the excitation signal $V_{iso1}$, the excitation signal $V_{iso2}$, the sampled voltage $V_{sam1}$, and the sampled voltage $V_{sam2}$.

An acquiring method of resistance values of the grounding impedance $R_{E1}$ and the grounding impedance $R_{E2}$ at step S5 may be as follows: according to the two excitation signals provided by the signal source $V_c$ and the two sampled voltages, two equations may be listed according to the formula (1):

$$\begin{cases} V_{sam1} \dfrac{R_2 + R_3}{R_2} = \dfrac{R_{E1}//(R_2 + R_3)//R_1}{R_{E2} + R_{E1}//(R_2 + R_3)//R_1} V_{pv} + \dfrac{R_{E1}//(R_2 + R_3)//R_{E2}}{R_1 + R_{E1}//(R_2 + R_3)//R_{E2}} V_{iso1} \\[4mm] V_{sam2} \dfrac{R_2 + R_3}{R_2} = \dfrac{R_{E1}//(R_2 + R_3)//R_1}{R_{E2} + R_{E1}//(R_2 + R_3)//R_1} V_{pv} + \dfrac{R_{E1}//(R_2 + R_3)//R_{E2}}{R_1 + R_{E1}//(R_2 + R_3)//R_{E2}} V_{iso2} \end{cases}$$

according to the above equations, the parallel resistance values of the ground impedance $R_{E1}$ and $R_{E2}$ may be obtained. The parallel resistance values of the ground impedance $R_{E1}$ and $R_{E2}$ may be as follows:

$$R_{E1}//R_{E2} = \frac{(V_{sam2} - V_{sam1})R_1(R_2 + R_3)}{(V_{sam1} - V_{sam2})(R_1 + R_2 + R_3) - R_2(V_{iso1} - V_{iso2})} \qquad (2)$$

In some embodiments, the controller 114 may control the signal source $V_c$ to output at least two different excitation signals, sample the division voltage between the two terminals of the second resistor R2 to obtain sampled voltages $V_{sami}$, acquire the grounding impedance according any two different excitation signals and the sampled voltages $V_{sami}$ corresponding to the two different excitation signals, and further average a plurality of obtained grounding impedances, thereby further improving accuracy of the measured grounding impedance.

In some embodiments, the sample module 113 may further include a second sampling unit 113b, which is connected to the direct-current input terminal of the inverter 100 and configured to acquire a direct-current input voltage and provide the direct-current input voltage to the controller 114, and the controller 114 is configured to control the signal source Vc to provide at least two different excitation signals and acquire the grounding impedance of the direct-current input terminal of the inverter 100 according to the at least two different excitation signals and the sampled voltages corresponding to the at least two different excitation signals.

In some embodiment, when the direct-current input voltage is unstable, the direct-current input voltage may be sampled under a corresponding excitation signal, and the parallel value of the grounding impedance $R_{E1}$ and the grounding impedance $R_{E2}$ of the direct-current input terminal of the inverter 100 may be acquired according to the at least two different excitation signals, the sampled voltages corresponding to the at least two different excitation signals, and the direct-current input voltage.

A formula for acquiring the parallel value of the grounding impedance $R_{E1}$ and the grounding impedance $R_{E2}$ may be as follows:

$$R_{E1}//R_{E2} = \frac{\left(V_{sam2}V_{pv1} - V_{sam1}V_{pv2}\right)R_1\left(R_2 + R_3\right)}{\left(V_{sam1}V_{pv2} - V_{sam2}V_{pv1}\right)\left(R_1 + R_2 + R_3\right) - R_2\left(V_{pv2}V_{iso1} - V_{pv1}V_{iso2}\right)}$$

Furthermore, it may be determined, according to the resistance value of the grounding impedance, whether a

7

grounding fault occurs in the direct current source 200.

Furthermore, the controller 114 may compare the parallel value of the grounding impedance $R_{E1}$ and the grounding impedance $R_{E2}$ with a preset threshold to determine whether the grounding impedance is abnormal and whether a grounding fault of the direct-current input terminal occurs. For example, when the parallel value is less than the preset threshold, it may be determined that the direct-current input terminal of the inverter has the grounding fault.

In some embodiments, the controller 114 may compare the grounding impedance $R_{E2}$ and the grounding impedance $R_{E1}$ with a corresponding preset threshold, respectively, determine whether the grounding impedance $R_{E1}$ and the grounding impedance $R_{E2}$ are abnormal, and determine whether a grounding fault occurs in the direct-current input terminal of the inverter.

In some embodiments, the excitation signal output by the signal source $V_c$ may include an alternating-current voltage $V_{isoac}$ with a fixed frequency, and the fixed frequency may be different from a power grid frequency. When only the alternating-current voltage with the fixed frequency is considered, the grounding impedance measurement apparatus 110 may be simplified as an alternating-current equivalent circuit model shown in FIG. 4. A parallel value of a grounding impedance $Z_{E1}$ and a grounding impedance $Z_{E2}$ may be calculated in the same manner, and it may be determined, by a resistance value, whether the ground impedance of the direct current source 200 is abnormal. The parallel value of the grounding impedance $Z_{E1}$ and the grounding impedance $Z_{E2}$ may be obtained by the following formulas.

$$V_{sam}\frac{R_2+R_3}{R_2}=V_{isoac}\frac{Z_{E1}//Z_{E2}//(R_2+R_3)}{R_1+Z_{E1}//Z_{E2}//(R_2+R_3)}$$

$$Z_{E1}//Z_{E2}=\frac{V_{sam}R_1(R_2+R_3)}{V_{isoac}R_2-V_{sam}(R_1+R_2+R_3)}$$

In the formulas, both $V_{isoac}$ and $V_{sam}$ may be AC voltage amplitudes corresponding to the frequency of the excitation signal.

Furthermore, the grounding impedance $Z_{E1}$ and the grounding impedance $Z_{E2}$ may be obtained by different excitation signals $V_{isoac}$ provided by the signal source $V_c$.

In some embodiments, the excitation signal output by the signal source $V_c$ may include a superposed signal of a direct-current signal and an alternating-current signal with a fixed frequency. Referring to a principle of the above embodiments, the grounding impedance of the direct-current input terminal of the inverter 100 may be obtained. Details may not be described herein again.

In some embodiments, referring to FIG. 5, the voltage division network 112 may be connected to the output terminal of the signal source $V_c$ and the coupling impedance network 111 in series, respectively.

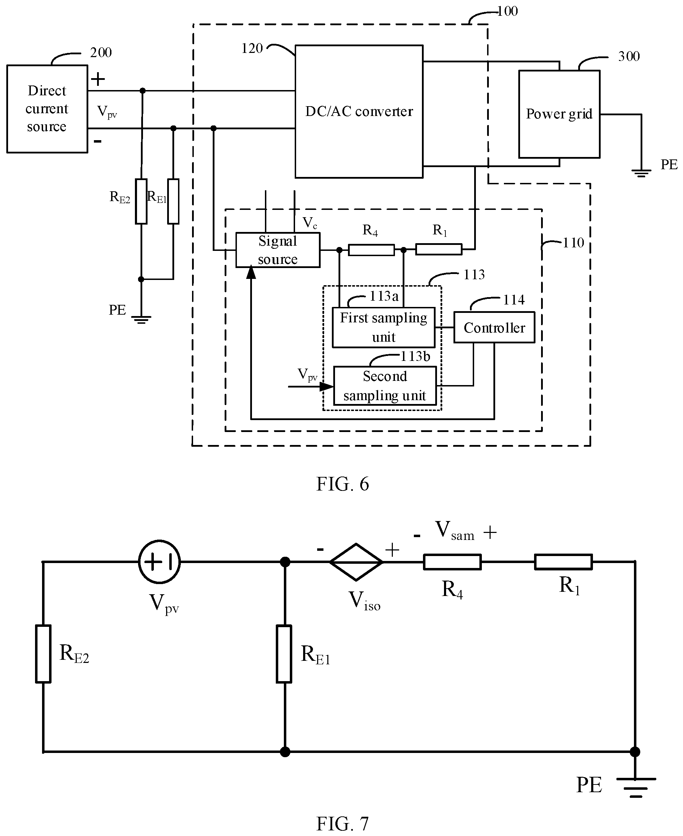

In some embodiments, referring to FIG. 6, the voltage division network 112 may include a fourth resistor $R_4$, the coupling impedance network 111 may include a first resistor $R_1$, the fourth resistor $R_4$ may be connected to the coupling impedance network 111 in series, and two terminals of the fourth resistor $R_4$ may provide a division voltage. The second output terminal of the signal source $V_c$ may be connected to the first terminal of the first resistor $R_1$ by the fourth resistor $R_4$, and a second terminal of the first resistor $R_1$ may be connected to the second port of the alternating-current output terminal.

In some embodiments, the second output terminal of the signal source $V_c$ may be connected to a first terminal of the fourth resistor $R_4$ by the first resistor $R_1$, and a second terminal of the fourth resistor $R_4$ may be connected to the second port of the alternating-current output terminal.

The first sampling unit 113a in the sampling module 113 is configured to sample a voltage between two terminals of the fourth resistor $R_4$ to obtain a sampled voltage and provide the sampled voltage to the controller 114, the second sampling unit 113b is configured to sample a voltage of the direct-current input terminal of the inverter 100 to obtain the direct-current input voltage and provide the sampled voltage to the controller 114.

Furthermore, a resistance value of the fourth resistor $R_4$ may be far less than that of the first resistor $R_1$.

Specifically, the direct-current equivalent circuit model of the grounding impedance measurement apparatus 110 may refer to FIG. 7. Steps of grounding impedance measurement in the present embodiment may be the same as that in the above embodiments, and the following equation may be obtained by the same derivation:

$$\begin{cases} V_{sam1}V_{pv2}\dfrac{R_1+R_4}{R_4} = \dfrac{R_{E1}//(R_1+R_4)}{R_{E2}+R_{E1}//(R_1+R_4)}V_{pv1}V_{pv2} - \dfrac{R_1+R_4}{R_1+R_4+R_{E1}//R_{E2}}V_{iso1}V_{pv2} \\[4mm] V_{sam2}V_{pv1}\dfrac{R_1+R_4}{R_4} = \dfrac{R_{E1}//(R_1+R_4)}{R_{E2}+R_{E1}//(R_1+R_4)}V_{pv2}V_{pv1} - \dfrac{R_1+R_4}{R_1+R_4+R_{E1}//R_{E2}}V_{iso2}V_{pv1} \end{cases}$$

Similarly, the parallel value of the grounding impedance $R_{E1}$ and the grounding impedance $R_{E2}$ may be obtained according to the above equation, and it may be determined, according to the parallel value, whether the ground impedance of the direct current source 200 is abnormal.

A structure and a connection manner of the voltage division network 112 may not be limited to the above specific embodiments, and may include other types of circuit structure, as long as the grounding impedance measurement can be performed with reference to the signal source $V_c$.

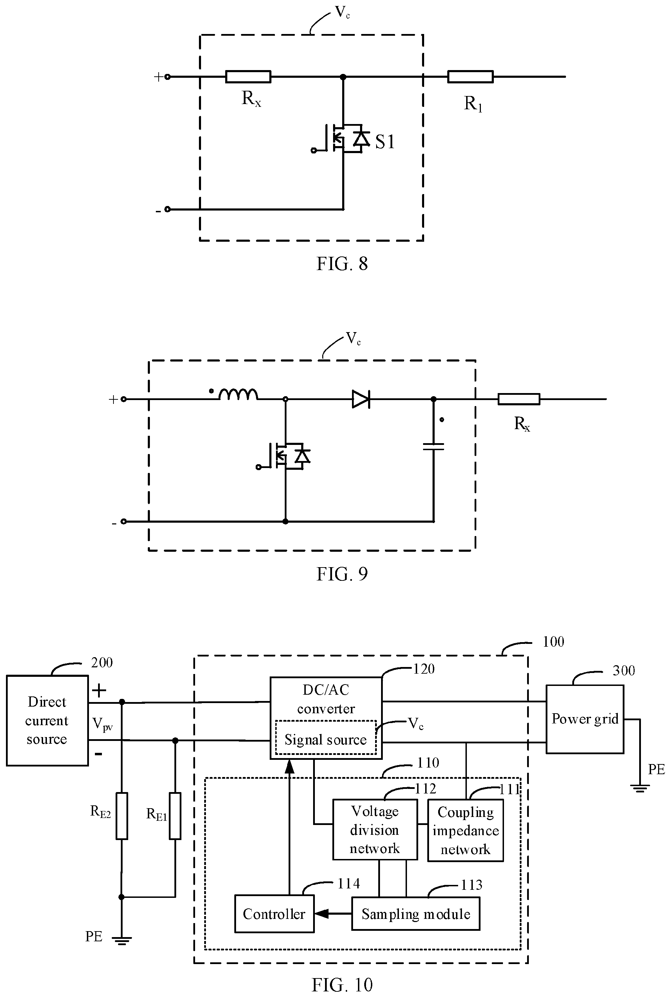

FIG. 8 is a schematic diagram of a circuit structure of the signal source $V_c$ in an embodiment of the present invention. Referring to FIG. 8, an input terminal of the signal source $V_c$ may be connected to, for example, the direct-current input terminal of the inverter 100. The signal source $V_c$ may include a switch circuit, including a switch transistor $S_1$ and a fifth resistor $R_x$. The switch transistor $S_1$ and the fifth resistor $R_x$ may be connected in series to the direct-current input terminal of the inverter 100. A connecting point of the switch transistor $S_1$ and the fifth resistor $R_x$ may be connected to the first terminal of the first resistor $R_1$. The excitation signal output by the signal source $V_c$ may be switched between 0 and $V_{pv}$ by controlling on/off state of the switch transistor $S_1$. Specifically, when the switch transistor $S_1$ is in an on state, the output excitation signal may be 0 V. When the switch transistor $S_1$ is in an off state, since a resistance value of the fifth resistor $R_x$ is far less than that of the first resistor $R_1$, the output excitation signal may be $V_{pv}$. The circuit structure may be simple and costs may be low.

To improve the difference between different excitation signals, FIG. 9 shows a schematic diagram of a circuit structure of the signal source $V_c$ in an embodiment of the present invention. Referring to FIG. 9, the signal source $V_c$ may be a boost converter, and the input terminal of the signal source $V_c$ may be connected to, for example, the direct-current input terminal of the inverter 100. The excitation signal may be generated according to the direct-current input voltage $V_{pv}$. The controller 114 may output multiple different excitation signals by controlling a duty ratio of the switch transistor in the signal source $V_c$, and a range of the output excitation signal may be flexibly adjusted.

In some embodiments, the signal source $V_c$ may include the boost converter and the switch circuit connected in series.

In some embodiments, the signal source $V_c$ may include other forms of DC voltage conversion circuit, such as a flyback topology.

In some embodiments, the signal source $V_c$ may include a rectifier circuit. In this case, the input terminal of the signal source $V_c$ may receive alternating current, for example, a power supply from the power grid.

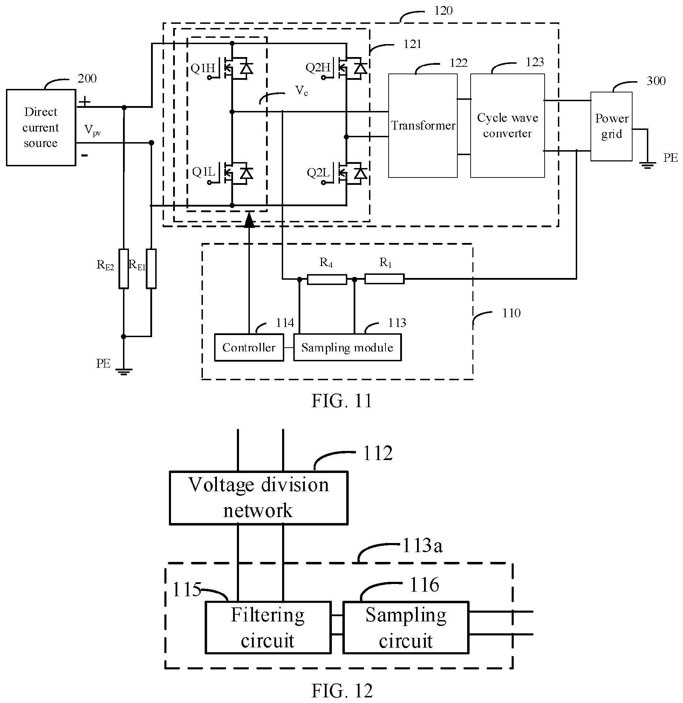

In some embodiments, the signal source $V_c$ may be a part of the DC/AC converter 120. Referring to FIG. 10 and FIG. 11, the DC/AC converter 120 may include an inverting unit 121, a transformer 122, and a cycle wave converter 123. The inverting unit 121 is configured to perform inversion, the transformer 122 may be connected to the inverting unit 121 and configured to perform boost and electrical isolation, and the cycle wave converter 123 may be connected to the transformer 122 and configured to perform AC-to-AC conversion.

Specifically, the inverting unit 121 may include a full-bridge circuit, including a switch transistor Q1H and a switch transistor Q1L connected in series, and a switch transistor Q2H and a switch transistor Q2L connected in series. The switch transistor Q1H and the switch transistor Q1L may constitute the signal source $V_c$, a connecting midpoint of the switch transistor Q1H and the switch transistor Q1L may provide the excitation signal, and the excitation signal may include the direct-current input voltage or 0.

In some embodiments, the switch transistor Q2H and the switch transistor Q2L may constitute the signal source $V_c$, a connecting midpoint of the switch transistor Q2H and the switch transistor Q2L may provide the excitation signal, and the excitation signal may include the direct-current input voltage or 0.

In some embodiments, the inverting unit 121 may include a half-bridge circuit. In this case, the half-bridge circuit may be the signal source $V_c$.

In some embodiments, referring to FIG. 12, the first sampling unit 113a may include a filtering circuit 115 and a sampling circuit 116, and the filtering circuit 115 may be connected to the voltage division network 112 and the sampling circuit 116, respectively, and configured to filter a voltage component in the sampled voltage other than a voltage component with a frequency of the excitation signal.

In some embodiments, the first sampling unit 113a may include an ADC (analog to digital converter) sampling unit. The controller 114 may receive a sampling voltage in a digital form. Correspondingly, the controller 114 may include a filtering unit configured to filter a voltage component in the sampled voltage other than a voltage component with the frequency of the excitation signal.

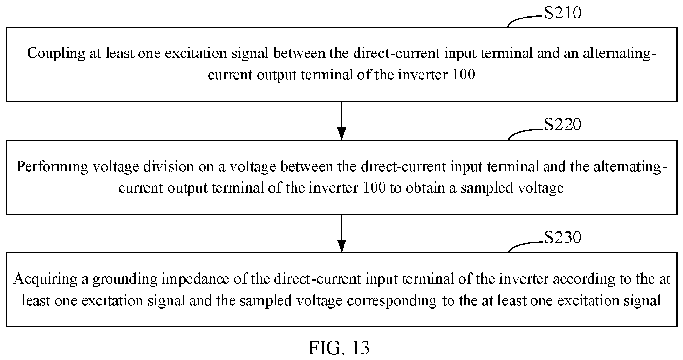

Furthermore, referring to FIG. 13, a grounding impedance measurement method is provided in the present invention, which is configured to measure a grounding impedance of a direct-current input terminal of an inverter 100. The method includes step 210 to step 230.

Step 210 includes coupling at least one excitation signal between the direct-current input terminal and an alternating-current output terminal of the inverter 100.

Step 220 includes performing voltage division on a voltage between the direct-current input terminal and the alternating-current output terminal of the inverter 100 to obtain a sampled voltage.

Step 230 includes acquiring a grounding impedance of the direct-current input terminal of the inverter according to the at least one excitation signal and the sampled voltage corresponding to the at least one excitation signal.

In some embodiments, the method may further include: coupling a first excitation signal and a second excitation signal between the direct-current input terminal and the alternating-current output terminal of the inverter 100, respectively; and acquiring a first sampled voltage corresponding to the first excitation signal and a second sampled voltage corresponding to the second excitation signal, respectively, and acquiring the grounding impedance of the direct-current input terminal of the inverter 100 according to a difference between the first excitation signal and the second excitation signal and a difference between the first sampled voltage and the second sampled voltage.

In some embodiments, the method may further include: coupling at least two different excitation signals between the direct-current input terminal and the alternating-current output terminal of the inverter 100, respectively; and acquiring direct-current input voltages of the direct-current input terminal of the inverter 100 and sampled voltages corresponding to the at least two different excitation signals, and acquiring the grounding impedance of the direct-current input terminal of the inverter 100 according to the at least two different excitation signals and the direct-current input voltages and the sampled voltages corresponding to the at least two different excitation signals.

In some embodiments, the method may further include comparing the grounding impedance with a preset threshold to determine whether the grounding impedance is abnormal.

An inverter 100 is provided in the present invention, including the above grounding impedance measurement apparatus 100 and the DC/AC converter 120.

In the present invention, the signal source $V_c$ and the coupling impedance network 111 are disposed between the direct-current input terminal and the alternating-current output terminal of the inverter 100, to construct a high-resistance circuit. The excitation signal is introduced into the high-resistance circuit, and the grounding impedance of the direct-current input terminal of the inverter 100 is acquired according to the excitation signal and the sampling voltage corresponding to the excitation signal. In a case that the inverter 100 has no grounding line, the grounding impedance of the direct-current input terminal of the inverter 100 may be measured.

The grounding impedance measurement apparatus 110, the grounding impedance measurement method, and the inverter 100 in the present invention may be corresponding to each other. Technical features and beneficial effects described in the above embodiments of the ground impedance measurement apparatus 110 may be applicable to the embodiments of both the ground impedance measurement method and the inverter 100.

The various technical features of the above embodiments may be combined arbitrarily, and all possible combinations of the various technical features of the above-described embodiments have not been described for the sake of conciseness of description. However, as long as there is no contradiction in the combinations of these technical features, they should be considered to be within the scope of the present description.

The above-described embodiments express only several embodiments of the present invention, which are described in a more specific and detailed manner, but are not to be construed as a limitation on the scope of the present invention. For the skill in the art, several deformations and improvements can be made without departing from the conception of the present invention, all of which fall within the scope of protection of the present invention. Therefore, the scope of protection of the present invention shall be subject to the attached claims.

**Claims**

1. A grounding impedance measurement apparatus, **characterized by** comprising a signal source, a coupling impedance network, a voltage division network, a sampling module, and a controller, wherein

   the signal source is configured to provide an excitation signal;
   the coupling impedance network is connected to the signal source, and configured to couple the excitation signal between a direct-current input terminal and an alternating-current output terminal of an inverter, wherein the alternating-current output terminal of the inverter is connected to a power grid;
   the voltage division network is configured to perform voltage division on a voltage between the direct-current input terminal and the alternating-current output terminal to provide a divided voltage;
   the sampling module is connected to the voltage division network, and configured to sample the divided voltage and acquire a sampled voltage;
the controller is connected to the signal source and the sampling module, respectively, and configured to control the signal source to provide at least one excitation signal and acquire a grounding impedance of the direct-current input terminal of the inverter according to the at least one excitation signal and the sampled voltage corresponding to the at least one excitation signal.

2. The grounding impedance measurement apparatus of claim 1, wherein the controller is further configured to control the signal source to provide a first excitation signal and a second excitation signal, respectively, the sampling module is further configured to acquire a first sampled voltage corresponding to the first excitation signal and a second sampled voltage corresponding to the second excitation signal, and the controller is further configured to acquire the grounding impedance of the direct-current input terminal of the inverter according to a difference between the first excitation signal and the second excitation signal and a difference between the first sampled voltage and the second sampled voltage.

3. The grounding impedance measurement apparatus of claim 1, wherein an output terminal of the signal source is connected to a port of the direct-current input terminal and the other output terminal of the signal source is connected to a port of the alternating-current output terminal via the coupling impedance network.

4. The grounding impedance measurement apparatus of claim 3, wherein the signal source comprises a direct-current voltage conversion circuit or a rectifier circuit.

5. The grounding impedance measurement apparatus of claim 3, wherein the signal source comprises a switch circuit, which comprises at least one switch, and different excitation signals are output by controlling an on-state of the at least one switch.

6. The grounding impedance measurement apparatus of claim 3, wherein the inverter comprises a full-bridge circuit or a half-bridge circuit, which is connected to the direct-current input terminal, the signal source is a part of the full-bridge circuit or a part of the half-bridge circuit, and the excitation signal comprises a direct-current input voltage of the direct-current input terminal or 0.

7. The grounding impedance measurement apparatus of claim 1, wherein the voltage division network is connected between a port of the direct-current input terminal of the inverter and a port of the alternating-current output terminal of the inverter.

8. The grounding impedance measurement apparatus of claim 1, wherein the voltage division network is connected to the coupling impedance network in series.

9. The grounding impedance measurement apparatus of claim 1, wherein the sampling module comprises a first sampling unit, which is connected to the voltage division network and configured to acquire the sampled voltage.

10. The grounding impedance measurement apparatus of claim 9, wherein the first sampling unit comprises a filtering circuit and a sampling circuit, and the filtering circuit is connected to the voltage division network and the sampling circuit, respectively, and configured to filter a voltage component in the sampled voltage other than a voltage component with a frequency of the excitation signal.

11. The grounding impedance measurement apparatus of claim 9, wherein the controller comprises a filtering unit configured to filter a voltage component in the sampled voltage other than a voltage component with a frequency of the excitation signal.

12. The grounding impedance measurement apparatus of claim 9, wherein the sampling module further comprises a second sampling unit connected to the direct-current input terminal of the inverter and configured to acquire a direct-current input voltage and provide the direct-current input voltage to the controller, and the controller is configured to control the signal source to provide at least two different excitation signals, and acquire the grounding impedance of the direct-current input terminal of the inverter according to the at least two different excitation signals and sampled voltages and direct-current input voltages corresponding to the at least two different excitation signals.

13. The grounding impedance measurement apparatus of claim 1, wherein the excitation signal comprises a direct-current signal, an alternating-current signal, or a superposed signal of a direct-current signal and an alternating-current signal.

14. The grounding impedance measurement apparatus of claim 1, wherein the controller is configured to compare the grounding impedance with a preset threshold to determine whether the grounding impedance is abnormal.

15. A grounding impedance measurement method, configured to measure a grounding impedance of a direct-current input terminal of an inverter, **characterized in that** the method comprises:

coupling at least one excitation signal between the direct-current input terminal and an alternating-current output terminal of the inverter;
performing voltage division on a voltage between the direct-current input terminal and the alternating-current output terminal of the inverter to obtain a sampled voltage; and
acquiring a grounding impedance of the direct-current input terminal of the inverter according to the at least one excitation signal and the sampled voltage corresponding to the at least one excitation signal.

16. The method of claim 15, further comprising:

coupling a first excitation signal and a second excitation signal between the direct-current input terminal and the alternating-current output terminal of the inverter, respectively; and
acquiring a first sampled voltage corresponding to the first excitation signal and a second sampled voltage corresponding to the second excitation signal, respectively, and acquiring the grounding impedance of the direct-current input terminal of the inverter according to a difference between the first excitation signal and the second excitation signal and a difference between the first sampled voltage and the second sampled voltage.

17. The method of claim 15, further comprising:

coupling at least two different excitation signals between the direct-current input terminal and the alternating-current output terminal of the inverter, respectively; and
acquiring direct-current input voltages of the direct-current input terminal of the inverter and sampled voltages corresponding to the at least two different excitation signals, and acquiring the grounding impedance of the direct-current input terminal of the inverter according to the at least two different excitation signals and the direct-current input voltages and the sampled voltages corresponding to the at least two different excitation signals.

18. The method of claim 17, further comprising:
comparing the grounding impedance with a preset threshold to determine whether the grounding impedance is abnormal.

19. An inverter, **characterized by** comprising the grounding impedance measurement apparatus of any one of claims 1 to 14 and a DC/AC converter, wherein the DC/AC converter is connected between the direct-current input terminal and the alternating-current output terminal of the inverter and configured to convert a direct current to an alternating current.

FIG. 1

FIG. 2

FIG. 3

FIG. 4

FIG. 5

FIG. 6

FIG. 7

FIG. 8

FIG. 9

FIG. 10

FIG. 11

FIG. 12

S210

Coupling at least one excitation signal between the direct-current input terminal and an alternating-current output terminal of the inverter 100

S220

Performing voltage division on a voltage between the direct-current input terminal and the alternating-current output terminal of the inverter 100 to obtain a sampled voltage

S230

Acquiring a grounding impedance of the direct-current input terminal of the inverter according to the at least one excitation signal and the sampled voltage corresponding to the at least one excitation signal

FIG. 13

## INTERNATIONAL SEARCH REPORT

| | International application No. |
|---|---|
| | **PCT/CN2023/125318** |

**A. CLASSIFICATION OF SUBJECT MATTER**

G01R27/20(2006.01)i; H02S50/00(2014.01)i

According to International Patent Classification (IPC) or to both national classification and IPC

**B. FIELDS SEARCHED**

Minimum documentation searched (classification system followed by classification symbols)

IPC:G01R H02S

Documentation searched other than minimum documentation to the extent that such documents are included in the fields searched

Electronic data base consulted during the international search (name of data base and, where practicable, search terms used)

CNTXT; CNKI; CJFD; ENTXTC; WPABS; ENTXT; IEEE: 杭州禾迈, 施科研, 禹红斌, 赵一, 杨波, 接地阻抗, 接地电阻, 接地阻值, 绝缘阻抗, 绝缘电阻, 绝缘阻值, 激励, 施加, 逆变器, 逆变系统, 逆变模块, 逆变电路, 直流, ground+ resistance, ground+ impedance, insulat+ resistance, insulat+ impedance, inverter, inject+, dc

**C. DOCUMENTS CONSIDERED TO BE RELEVANT**

| Category* | Citation of document, with indication, where appropriate, of the relevant passages | Relevant to claim No. |
|---|---|---|
| PX | CN 116087624 A (HANGZHOU HOYMILES POWER ELECTRONICS CO., LTD.) 09 May 2023 (2023-05-09)<br>description, paragraphs [0005]-[0037], and figures 1-13 | 1-19 |
| A | CN 115327234 A (SUNGROW POWER SUPPLY CO., LTD.) 11 November 2022 (2022-11-11)<br>description, paragraphs [0032]-[0038], [0047], [0048], and [0054], and figures 1-4 | 1-19 |
| A | CN 108896822 A (SUNGROW POWER SUPPLY CO., LTD.) 27 November 2018 (2018-11-27)<br>entire document | 1-19 |
| A | CN 110456154 A (HUAWEI TECHNOLOGIES CO., LTD.) 15 November 2019 (2019-11-15)<br>entire document | 1-19 |
| A | CN 113252980 A (HUAWEI TECHNOLOGIES CO., LTD.) 13 August 2021 (2021-08-13)<br>entire document | 1-19 |
| A | EP 3109647 A1 (ABB TECHNOLOGY AG.) 28 December 2016 (2016-12-28)<br>entire document | 1-19 |

☐ Further documents are listed in the continuation of Box C.  ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **01 December 2023** | **11 December 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/125318**

| Patent document cited in search report | | | Publication date (day/month/year) | Patent family member(s) | | | Publication date (day/month/year) |
|---|---|---|---|---|---|---|---|
| CN | 116087624 | A | 09 May 2023 | None | | | |
| CN | 115327234 | A | 11 November 2022 | None | | | |
| CN | 108896822 | A | 27 November 2018 | None | | | |
| CN | 110456154 | A | 15 November 2019 | None | | | |
| CN | 113252980 | A | 13 August 2021 | None | | | |
| EP | 3109647 | A1 | 28 December 2016 | EP | 3109647 | B1 | 18 November 2020 |

Form PCT/ISA/210 (patent family annex) (July 2022)

**EP 4 610 672 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211591079